(19) Europäisches Patentamt
European Patent Office
Office européen des brevets

(11) **EP 3 421 875 B1**

(12) **FASCICULE DE BREVET EUROPEEN**

(45) Date de publication et mention de la délivrance du brevet:
**31.08.2022 Bulletin 2022/35**

(21) Numéro de dépôt: **18180218.2**

(22) Date de dépôt: **27.06.2018**

(51) Classification Internationale des Brevets (IPC):
*F21S 43/14* (2018.01)    *F21S 41/153* (2018.01)
*F21S 41/663* (2018.01)    *F21S 41/25* (2018.01)
*F21S 41/151* (2018.01)    *F21S 41/255* (2018.01)
*F21W 102/14* (2018.01)

(52) Classification Coopérative des Brevets (CPC):
**F21S 41/151; F21S 41/153; F21S 41/25;
F21S 41/255; F21S 41/663; F21S 43/14;**
F21W 2102/14

(54) **MODULE LUMINEUX COMPORTANT UN ELEMENT OPTIQUE DE CORRECTION DE CHAMP**

LEUCHTMODUL, DAS EIN OPTISCHES FELDKORREKTURELEMENT UMFASST

LIGHT MODULE COMPRISING AN OPTICAL FIELD-CORRECTION ELEMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.06.2017 FR 1756064**

(43) Date de publication de la demande:
**02.01.2019 Bulletin 2019/01**

(73) Titulaire: **Valeo Vision**
**93012 Bobigny Cedex (FR)**

(72) Inventeurs:
• **COURCIER, Marine**
**85774 Unterfoehring (DE)**
• **JOERG, Alexandre**
**93012 BOBIGNY Cedex (FR)**

(74) Mandataire: **Valeo Visibility**
**Service Propriété Industrielle**
**c/o Valeo Vision**
**34, rue Saint André**
**93012 Bobigny (FR)**

(56) Documents cités:
**EP-A1- 2 871 406**    **EP-A1- 2 979 926**
**EP-A1- 3 147 557**    **EP-A1- 3 301 349**
**WO-A1-2014/087035**    **WO-A1-2017/015684**
**DE-A1-102008 061 556**    **US-A1- 2013 208 493**
**US-A1- 2016 341 386**    **US-A1- 2018 128 443**

**Description**

L'invention se rapporte au domaine des modules lumineux pour véhicules automobiles, et plus particulièrement des modules lumineux aptes à produire un faisceau lumineux à segments pour la réalisation d'une fonction d'éclairage matriciel. Elle concerne plus particulièrement une lentille optique de correction de champ intégrée dans un module lumineux pour l'émission d'un faisceau matriciel, en travers des rayons lumineux émis par une matrice de sources lumineuses primaires.

Le domaine technique de l'invention est celui des dispositifs d'éclairage ou de signalisation pour véhicule automobile comportant au moins un premier module lumineux, apte à remplir une fonction d'éclairage matriciel tel qu'un feu de route adaptatif, aussi connu sous l'appellation « ADB » pour « Adaptative Driving Beam ».

La fonction d'éclairage adaptatif "ADB" est mise en œuvre dans les dispositifs d'éclairage par l'intermédiaire de modules lumineux particuliers et par des organes de détection appropriés tournés vers la scène de route devant le véhicule. On peut de la sorte détecter de façon automatique un usager de la route susceptible d'être ébloui par un faisceau d'éclairage émis en mode feu de route par un projecteur, et modifier le contour de ce faisceau d'éclairage de manière à créer une zone d'ombre à l'endroit où se trouve l'usager détecté tout en continuant à éclairer la route à grande portée de part et d'autre de l'usager. Les avantages de la fonction ADB sont multiples : confort d'utilisation, meilleure visibilité par rapport à un éclairage en mode feu de croisement, risque d'éblouissement fortement réduit, conduite plus sûre...

On connaît déjà des modules lumineux permettant de remplir cette fonction d'éclairage matriciel. Ils sont aptes à émettre longitudinalement vers l'avant un faisceau lumineux, dit "matrixbeam" ou encore "pixel beam", composé d'une pluralité de faisceaux élémentaires qui se chevauchent. Le faisceau lumineux global projette vers l'avant une image de la matrice de sources lumineuses élémentaires. En allumant ou en éteignant sélectivement chacune des sources élémentaires, il est possible de créer un faisceau lumineux global éclairant spécifiquement certaines zones de la route en avant du véhicule, tout en laissant dans l'obscurité d'autres zones.

Plus particulièrement, un tel module comporte généralement une matrice de sources lumineuses primaires, généralement formées par des diodes électroluminescentes (LEDs), un élément optique primaire comportant une pluralité de guides de lumière et une optique de projection. Les guides de lumières sont destinés à conformer les rayons émis par les diodes électroluminescentes en un pinceau lumineux plus étroit présentant la forme d'un pixel, généralement rectangulaire ou carré. Les faces de sortie des guides de lumière forment une matrice de sources lumineuses secondaires imagées par l'optique de projection. Un tel module est montré par exemple dans la demande de brevet WO2017/015684 A1.

En outre, pour permettre de focaliser correctement l'optique de projection sur les sources de lumière élémentaires secondaires, un élément optique de correction de champ peut être interposé entre d'une part le plan d'émission formé par l'agencement des faces de sortie des guides de lumière et d'autre part l'optique de projection. Ainsi, toutes les sources lumineuses sont imagées de manière nette par l'optique de projection ce qui permet d'éclairer au mieux autour des autres véhicules tout en évitant d'éblouir les autres conducteurs. De manière connue, un tel élément optique de correction de champ est formé par une lentille comportant une face d'entrée de forme concave ou convexe ou plane et une face de sortie de forme convexe Un module lumineux pour véhicule comprenant un élément optique de correction de champ est montré dans la demande de brevet EP3301349 AI qui fait partie de l'état de la technique selon l'article 54(3) CBE.

On comprend que dans un module configuré pour réaliser un faisceau adaptatif, les diodes électroluminescentes peuvent être allumées indépendamment l'une de l'autre, de façon sélective. Pour éviter tout éblouissement d'un usager de véhicule arrivant en sens inverse, il est habituel de projeter un faisceau lumineux avec une bande sombre. Pour ce faire, sur une rangée transversale de diodes électroluminescentes de la matrice de sources lumineuses primaires d'émission de lumière, il convient d'éteindre une ou plusieurs diodes électroluminescentes, immédiatement voisine(s) de diodes électroluminescentes qui elles restent allumées pour former le reste du faisceau.

Tel qu'il a été présenté précédemment, le module d'éclairage ne permet pas d'obtenir un contraste totalement net entre la bande sombre et les parties éclairées du faisceau qui l'entourent, notamment du fait que la face d'entrée de la lentille formant l'élément optique de correction de champ, par laquelle les rayons émis par les sources lumineuses pénètrent dans la lentille, est de forme concave. En effet, dans cette configuration, la diode électroluminescente allumée émet un rayon lumineux qui, après réfraction au niveau de la face de sortie du guide de lumière correspondant de l'élément optique primaire, est partiellement réfléchi sur la face d'entrée concave de la lentille pour revenir en direction de l'élément optique primaire mais avec un décalage transversal qui dirige ce rayon vers une face de sortie d'un guide de lumière voisine à celle ayant été traversée par le rayon lumineux à l'aller, ce qui génère un problème lorsque cette face de sortie voisine correspondant à une diode électroluminescente éteinte pour former la zone d'assombrissement. En effet, une partie du rayon revenu en direction de l'élément optique primaire est renvoyé vers la lentille formant l'élément optique de correction de champ, depuis une zone où théoriquement aucun rayon ne devrait être émis pour avoir une zone la plus sombre possible.

La présente invention vise à résoudre ce problème en proposant un module lumineux d'éclairage adaptatif pour véhicule automobile comportant un élément optique de correction de champ comportant un revêtement antireflet sur au moins une portion d'une de ses faces en vue de réduire les rayonnements parasites par augmentation du taux de transmission des rayons lumineux incidents en provenance d'une source lumineuse et améliorer ainsi les performances d'un module d'éclairage d'un véhicule automobile.

L'invention a plus particulièrement pour objet un module lumineux d'éclairage adaptatif pour véhicule automobile comportant un élément optique de correction de champ configuré pour être agencé dans un dispositif d'éclairage adaptatif en travers de rayons lumineux émis par une pluralité de sources lumineuses, l'élément optique comprenant une face d'entrée de rayons lumineux et une face de sortie de ces rayons lumineux. Selon un premier aspect de l'invention, au moins une portion de la face d'entrée est recouverte d'un revêtement antireflet apte à diminuer la réflexion d'une partie des rayons lumineux par cette face d'entrée.

On comprend que la diminution de la réflexion parasite de ces rayons permet d'éviter le renvoi de rayons lumineux vers les sources lumineuses, et de conserver de la sorte une précision de l'émission des rayons lumineux, nécessaire à la réalisation d'une fonction d'éclairage adaptatif. La mesure de cette diminution de la réflexion des rayons parasites peut notamment être effectuée en mesurant le taux de transmission des rayons lumineux à travers l'élément optique.

Selon différentes caractéristiques de l'invention, prises seules ou en combinaison, on peut prévoir que :

- la face d'entrée de rayons lumineux est concave ; on comprend ici que l'on définit la concavité, et plus loin la convexité, d'une face d'entrée ou de sortie par rapport à l'élément optique de correction lui-même, c'est-à-dire par rapport au centre de celui-ci ; en d'autres termes, la face d'entrée de l'élément optique de correction est concave en ce qu'elle présente un profil courbe vers l'intérieur de l'élément optique de correction : la partie centrale de la face d'entrée, centrée sur l'axe optique de l'élément optique de correction, est ainsi plus à l'intérieur de cet élément optique de correction que les bords de cette face d'entrée ;
- le dioptre formé au niveau de la face d'entrée et son revêtement antireflet est configuré pour présenter, pour une incidence normale, un taux de transmission au moins égal à 97%.

Selon un deuxième aspect de l'invention, au moins une portion de la face de sortie est recouverte d'un revêtement antireflet apte à diminuer la réflexion d'une partie des rayons lumineux par cette face de sortie.

La face de sortie de rayons lumineux peut être convexe ; conformément à ce qui précède, on comprend que la face de sortie de l'élément optique de correction est convexe en ce qu'elle présente un profil courbe vers l'extérieur de l'élément optique de correction : la partie centrale de la face de sortie, centrée sur l'axe optique de l'élément optique de correction, est ainsi plus à l'extérieur de cet élément optique de correction que les bords de cette face de sortie.

Dans un premier mode de réalisation, le revêtement antireflet d'au moins une portion de la face d'entrée de l'élément optique de correction de champ selon l'invention comporte avantageusement l'une quelconque au moins des caractéristiques suivantes, prises seules ou en combinaison :

- le revêtement antireflet est un revêtement monocouche de matériau à faible indice de réfraction, de préférence de fluorure de magnésium $MgF_2$ ;
- la monocouche dudit matériau à faible indice de réfraction présente une épaisseur égale à $\lambda / 4.n$, avec $\lambda$ la longueur d'onde du centrage de l'anti-reflet et $n$ l'indice de réfraction dudit matériau.
- la monocouche dudit matériau à faible indice de réfraction, de préférence de fluorure de magnésium $MgF_2$, présente une épaisseur de 101 nm pour un indice de réfraction $n=1,36$ à une longueur d'onde de 550 nm.

Dans un deuxième mode de réalisation, le revêtement antireflet d'au moins une portion de la face d'entrée de l'élément optique de correction de champ selon l'invention comporte avantageusement l'une quelconque au moins des caractéristiques suivantes, prises seules ou en combinaison :

- le revêtement antireflet est un revêtement monocouche hybride dans laquelle est dispersée une pluralité de particules hybrides comportant chacune au moins deux éléments de nature et d'indice de réfraction distincts ; de préférence, chaque particule hybride est constituée d'un premier élément d'indice de réfraction n1 entouré d'un second élément d'indice de réfaction n2 formant une couche d'enrobage ;
- les premier et second éléments d'une particule hybride peuvent être de nature organique et/ou inorganique et/ou polymère, de préférence le premier élément est constitué d'au moins un alcoxyde minéral pris seul ou en mélange, de préférence un alcoxysilane pouvant avoir jusqu'à quatre groupes hydrolysables.

Dans un troisième mode de réalisation, le revêtement antireflet d'au moins une portion de la face d'entrée de l'élément optique de correction de champ selon l'invention comporte avantageusement l'une quelconque au moins des caractéristiques suivantes, prises seules ou en combinaison :

- le revêtement antireflet est un revêtement multicouche d'au moins deux couches d'indices de réfraction distincts ;
- le revêtement multicouche est composé d'une alternance d'au moins une couche d'un matériau à haut indice de réfraction et d'au moins une couche d'un matériau à faible indice de réfraction ; l'épaisseur d'une couche dépend de l'indice de réfraction pour une longueur d'onde sélectionnée ;
- le matériau à faible indice de réfraction est choisi parmi les matériaux ayant un indice de réfraction inférieur à 1,6 pour une longueur d'onde de 550 nm ;
- le matériau à faible indice de réfraction est choisi parmi $SiO_2$, $MgF_2$, $LiF$, $CaF_2$, $NaF$, $ZrF_4$, $AlF_3$, $Na_5Al_3F_{14}$, $Na_3AlF_6$ pris seul ou en mélange ;
- le matériau à haut indice de réfraction est choisi parmi les matériaux ayant un indice de réfraction supérieur à 1.7 pour une longueur d'onde de 550 nm ;
- le matériau à haut indice de réfraction est choisi parmi $ZrO_2$, $TiO_2$, $Ta_2O_5$, $Na_2O_5$, $SnO_2$, $ZnO$, $ZnS$, $HfO_2$, $Pr_2O_3$, $PrTiO_3$, $La_2O_3$, $Dy_2O_5$, $In_2O_3$, $Nb_2O_5$, $Yb_2O_3$, $Si_3N_4$, $AlN$ pris seul ou en mélange.

Dans un mode de réalisation non-couvert par les revendications, on considère un procédé de fabrication d'un élément optique de correction de champ qui comprend une face d'entrée concave et une face de sortie convexe de rayons lumineux émis par une pluralité de sources de lumière, et qui est configurée pour être agencée dans un dispositif lumineux adaptatif. Le procédé comporte au moins une étape d'application d'un revêtement antireflet sur au moins une portion d'au moins une face de l'élément optique de correction de champ, de préférence la face d'entrée concave. On confère de la sorte des propriétés antireflets à ladite face constituant un substrat transparent à base de verre ou de polycarbonates en cherchant à augmenter le taux de transmission des rayons lumineux pour des longueurs d'ondes spécifiques.

Selon différentes caractéristiques, prises seules ou en combinaison, on peut prévoir que :

- l'étape d'application consiste à déposer au moins une couche de revêtement antireflet selon un procédé sous vide, de préférence par dépôt physique en phase vapeur ;
- l'étape d'application consiste à déposer un revêtement antireflet formant une monocouche, telle que décrite précédemment, où la monocouche est constituée d'un matériau à faible indice de réfraction et présente une épaisseur inférieure à 1 micromètre, de préférence une monocouche de $MgF_2$ d'une épaisseur de 101 nm avec un indice de réfraction de 1,36 à 550 nm ;
- l'étape d'application consiste à déposer successivement une alternance d'au moins deux couches d'indices de réfraction distincts de manière à constituer un revêtement antireflet multicouche.

Selon d'autres caractéristiques, prises seules ou en combinaison, on peut prévoir que :

- l'étape d'application consiste à déposer au moins une couche de revêtement antireflet selon un procédé sol-gel par une technique de dépôt par voie liquide réalisée à pression atmosphérique et à température ambiante pouvant être un dépôt par trempage ou un dépôt par enduction centrifuge ou un dépôt par pulvérisation ou encore par enduction laminaire ;
- la monocouche obtenue après immersion dans la solution sol-gel constitue une monocouche hybride, telle que décrite précédemment, dans laquelle sont dispersées des particules hybrides comportant chacune au moins deux éléments de nature et d'indice de réfraction distincts ;
- l'étape d'application consiste à déposer une monocouche de revêtement antireflet selon la technique de dépôt par trempage, comportant une étape d'immersion du substrat dans une solution sol-gel suivie d'un traitement thermique ou séchage.
- chaque particule hybride est constituée d'un premier élément d'indice de réfraction n1 entouré d'un second élément d'indice de réfaction n2 formant une couche d'enrobage ;
- les premier et second éléments peuvent être de nature organique et/ou inorganique et/ou polymère ;
- la monocouche hybride a une épaisseur comprise entre 10 nanomètres et 10 micromètres, fonction de l'indice de réfraction et du centrage de l'antireflet ; notamment, la monocouche hybride peut présenter une épaisseur de 101 nanomètres pour un indice de réfraction allant de 1,32 à 1,36 en fonction du matériau et un centrage de l'antireflet sur 550 nm ;
- le procédé sol-gel repose sur une première étape d'hydrolyse d'au moins un alcoxyde minéral pris seul ou en mélange, de préférence un alcoxysilane pouvant avoir jusqu'à quatre groupes hydrolysables, de préférence encore un tétraalcoxysilane, par exemple le tétraméthoxysilane (TMOS) ou le tétraéthoxysilnae (TEOS), ou un alcoxyde de titane, par exemple l'isopropoxyde de titane, ou bien encore un alcoxyde de zinc, par exemple l'isopropoxyde de zinc, suivie d'une deuxième étape de condensation ;
- l'au moins un alcoxyde minéral est un alcoxysilane est mélangé à au moins un monomère réticulable sous UV ou sous l'effet d'un traitement thermique, de préférence des composés porteurs de groupes méthacrylate, acrylate époxy, ou vinyléther, de manière à obtenir un durcissement supplémentaire ;
- le mélange obtenu peut, en outre, comporter un tensioactif, de préférence un tensioactif polyoxyéthyléné.

Un module lumineux selon l'invention peut comporter en outre :

- des sources lumineuses primaires configurées pour émettre des rayons lumineux depuis un substrat commun, le substrat pouvant à titre d'exemple être plan et orthogonal à l'axe optique du module lumineux,
- un élément optique primaire comportant une portion avant formant lentille et une portion arrière qui comporte une pluralité de guides de lumières, chaque guide de lumière comportant une face d'entrée de rayons lumineux émis par une source lumineuse primaire associée et une face de sortie de ces rayons lumineux en direction de la portion avant formant lentille, ces faces de sortie pouvant notamment être confondues avec une partie centrale de la portion avant formant lentille, et
- une optique de projection apte à projeter une image des faces de sortie des guides de lumière pour former un faisceau lumineux global adaptatif, avec l'élément optique formant correction de champ qui est agencé sur l'axe optique du module lumineux entre l'élément optique primaire et l'optique de projection, la face d'entrée de cet élément optique formant correction de champ qui est recouverte au moins partiellement d'un revêtement antireflet étant tournée vers l'élément optique primaire.

Selon différentes caractéristiques du module lumineux de l'invention, prises seules ou en combinaison, on peut prévoir que :

- les sources lumineuses primaires sont agencées en une matrice, qui s'étend majoritairement dans un plan orthogonal à la direction longitudinale de l'axe (A) optique, et qui présente au moins une rangée transversale d'une pluralité de diodes électroluminescentes portées par la face avant d'une carte à circuits imprimés ;
- chaque diode électroluminescente est commandée individuellement ; la matrice de sources lumineuses élémentaires primaires peut alors être configurée de manière à comporter une série de diodes électroluminescentes éteintes adjacente à une série de diodes électroluminescentes allumées, en vue d'obtenir un faisceau lumineux final dont le contour est modifié par une bande sombre ;
- la portion d'une face de l'élément optique de correction de champ recouverte par un revêtement antireflet s'étend sur une hauteur, selon une première direction perpendiculaire à l'axe optique dudit élément optique, qui dépend de la distance entre la face d'entrée d'un guide de lumière et la face de cet élément optique et de la longueur dudit guide de lumière, ainsi que de la hauteur du guide de lumière au niveau de sa face de sortie selon la première direction, selon la formule :

$$(H1, H2) = (D1, D2) * H/d$$

Dans un mode de réalisation non-couvert par les revendications, un véhicule automobile peut être équipé d'un dispositif d'éclairage apte à réaliser une fonction d'éclairage adaptatif de type «ADB», caractérisé en ce qu'il comporte un module lumineux avec un élément optique de correction de champ tel que décrit précédemment.

D'autres caractéristiques et avantages de l'invention apparaitront plus clairement à la lecture de la description détaillée des modes de réalisation de l'invention, donnée ci-après à titre d'exemple illustratif et non limitatif et s'appuyant sur les figures annexées, parmi lesquelles :

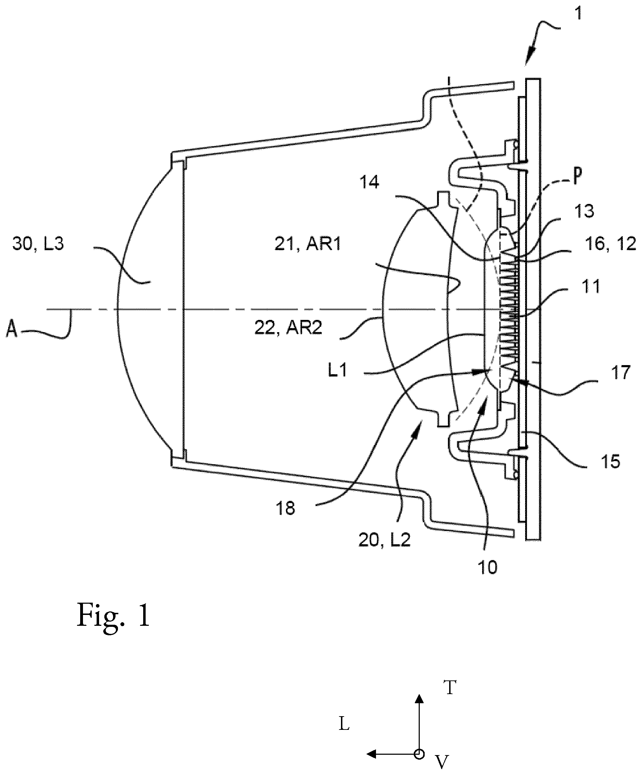

- la figure 1 est une vue en coupe, dans un plan de coupe comprenant l'axe (A) optique longitudinal de l'optique de projection, d'un module lumineux apte à remplir une fonction de feu de route adaptatif de type « ADB » dans un dispositif d'éclairage ou de signalisation pour véhicule automobile, le module lumineux comportant une lentille optique L2 de correction de champ selon l'invention ; et

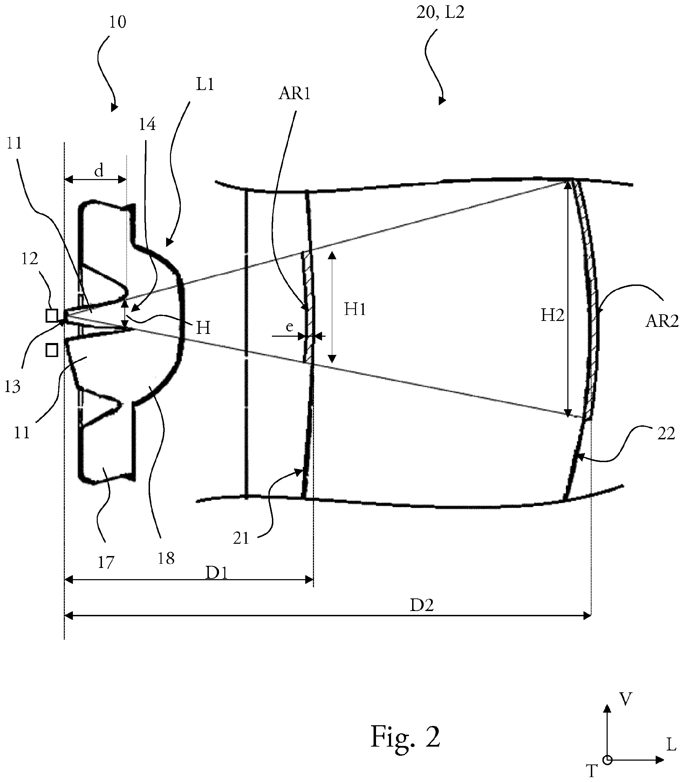

- la figure 2 est une vue de détail en coupe transversale verticale selon une orientation longitudinale « L » de l'axe (A) optique longitudinal, d'une lentille optique L2 de correction de champ selon l'invention configurée pour être agencée dans un système optique pixel comportant une pluralité de guides de lumière.

Il est tout d'abord à noter que si les figures exposent l'invention de manière détaillée pour sa mise en œuvre, elles peuvent bien entendu servir à mieux définir l'invention le cas échéant. De même, il est rappelé que, pour l'ensemble des figures, les mêmes éléments sont désignés par les mêmes repères. On comprendra également que les modes de réalisation de l'invention illustrés par les figures sont données à titre d'exemple non limitatif.

Il est également rappelé que, dans la description qui suit, la dénomination "avant" se réfère à la direction du faisceau lumineux final émis longitudinalement vers l'avant, c'est-à-dire en sortie du module lumineux selon l'invention.

L'invention prend application pour un véhicule automobile équipé d'un dispositif d'éclairage apte à réaliser une fonction d'éclairage adaptatif de type dite "ADB ». Ce dispositif d'éclairage comporte notamment un module lumineux tel qu'il va être décrit en référence à la figure 1, et dans lequel il est notable qu'un élément optique de correction de champ est recouvert au moins en partie par un revêtement antireflet.

La figure 1 illustre un module lumineux 1 équipé d'un élément optique de correction de champ 20 selon l'invention, et plus particulièrement dans un cas où l'élément optique de correction de champ est formé par une lentille L2.

Le module lumineux 1 présente un axe (A) optique longitudinal et il est configuré pour émettre un faisceau lumineux final adaptatif longitudinalement vers l'avant pour remplir une fonction de feu de route adaptatif dit « ADB » dans un dispositif d'éclairage ou de signalisation pour véhicule automobile.

Suivant la direction longitudinale « L » de l'axe optique, le module comporte, de l'arrière vers l'avant, une matrice 16 de sources lumineuses primaires formées ici par des diodes électroluminescentes parmi lesquelles chacune est apte à émettre un faisceau élémentaire primaire depuis un plan commun d'émission orthogonal de l'axe optique, puis un élément optique primaire 10 agencé à la suite de la matrice 16 de diodes électroluminescentes 12 pour modifier la distribution des rayons lumineux émis, puis l'élément optique de correction de champ 20 et une optique de projection 30, l'élément optique de correction de champ étant destiné à corriger la trajectoire des rayons en sortie de l'élément optique primaire sur l'optique de projection 30 pour une projection nette vers l'infini de l'ensemble du faisceau lumineux final adaptatif.

La matrice 16, qui s'étend dans un plan orthogonal à la direction longitudinale « L », est équipée ici de deux rangées transversales de dix-sept diodes électroluminescentes 12 portées par la face avant d'une carte de circuits imprimés 15 et agencées l'une au-dessus de l'autre tel que cela est visible sur la figure 2. Chaque diode électroluminescente 12 peut être commandée individuellement par l'intermédiaire d'une électronique de contrôle et de la carte de circuits imprimés 15. En vue de créer un faisceau adaptatif, c'est-à-dire un faisceau lumineux global comportant en son sein une zone sombre, chaque rangée transversale de diodes électroluminescentes 12 peut être commandée pour former au moins un ensemble de diodes allumées et au moins une ou un ensemble de diodes successives éteintes.

L'élément optique primaire 10 comporte ici une première portion arrière 17, qui est formée d'une pluralité de guides de lumière 11 et qui est tournée vers la matrice 16 de sources de lumière primaires, et une deuxième portion avant 18 de mise en forme des faisceaux lumineux émis par les sources lumineuses secondaires, de manière à former une lentille L1.

Dans la première portion arrière 17 de l'élément optique primaire, un guide de lumière 11 est prévu pour être disposé en regard d'une diode électroluminescente 12, de sorte que dans le mode de réalisation illustré, deux rangées de guides de lumière sont agencées l'une au-dessus de l'autre, étant entendu que l'on pourrait, sans sortir du contexte de l'invention, avoir un nombre de rangées différent et par exemple une unique rangée de diodes et de guide de lumière, ou un système à trois rangées. Chaque guide de lumière 11 s'étend selon un axe principal longitudinal depuis une face d'entrée 13, disposée en regard de la diode électroluminescente 12 correspondante de manière à ce que la majeure partie des rayons lumineux émis par chaque diode 12 entre dans le guide de lumière 11 associé, jusqu'à une face d'extrémité avant, ou face de sortie 14 des rayons lumineux.

Chaque guide de lumière 11 est conçu pour guider, par des réflexions internes successives, les rayons entrant par la face d'entrée 13 jusqu'à la face de sortie 14.

La lumière sortant par la face de sortie 14 débouche dans la deuxième portion avant 18, qui forme une lentille L1 de mise en forme des rayons lumineux pour les diriger vers l'optique de projection 30 via l'élément optique de correction de champ 20. La lentille L1 formée par la deuxième portion avant 18 est disposée ici dans le prolongement direct des guides de lumière 11, ceux-ci et la deuxième portion avant 18 étant issus de la même matière pour former un élément optique primaire d'un seul tenant. Il en résulte que la forme des rayons lumineux donnée par la face de sortie 14 d'un guide de lumière génère une source lumineuse secondaire. Dans l'exemple illustré, les faces de sortie 14 des guides de lumière forment une matrice de deux rangées de chacune dix-sept sources lumineuses secondaires.

L'élément optique de correction de champ 20 présente ici la forme d'une lentille comprenant une face d'entrée 21 des rayons lumineux émis par chaque diode, disposée en regard de l'élément optique primaire 10, qui est concave et une face de sortie 22 de ces rayons corrigés, disposée en regard de l'optique de projection 30, qui est convexe.

Selon l'invention, au moins une portion d'une des faces 21, 22 de la lentille L2, respectivement d'entrée concave et de sortie convexe, est recouverte d'un revêtement antireflet AR1, AR2 apte à augmenter le taux de transmission des rayons lumineux incidents provenant de la lentille L1 de l'élément optique primaire 10 et initialement émises par les diodes électroluminescentes 12 allumées.

On va maintenant décrire plus en détails l'élément optique de correction de champ et le revêtement antireflet qui est prévu pour recouvrir au moins en partie cet élément optique de correction de champ, et notamment au niveau de sa face d'entrée par laquelle les rayons émis par les sources lumineuses pénètrent dans l'élément optique de correction de champ.

La figure 2 illustre en coupe une partie de l'élément optique primaire 10, rendant visible deux guides de lumière agencés l'un au-dessus de l'autre de manière à être en regard de deux diodes électroluminescentes représentés schématiquement, et une partie d'une lentille L2 formant l'élément optique de correction de champ 20 selon l'invention.

Dans l'exemple illustré, une première couche de revêtement antireflet AR1 a été déposée partiellement sur la face d'entrée 21 des rayons, et une deuxième couche de revêtement antireflet AR2 a été déposée partiellement sur la face de sortie 22 de rayons lumineux incidents, et on comprend que l'épaisseur de ces couches de revêtement a ici été exagérée pour les rendre visibles sur la figure.

Tel que cela a pu être précisé précédemment, chacune de ces couches de revêtement a pour effet d'augmenter le taux de transmission d'au moins un rayon lumineux incident. Dès lors, la quantité de rayons lumineux susceptibles d'être réfléchis par la face d'entrée 21 des rayons en direction de l'élément optique primaire avec un décalage transversal tel que le rayon issu d'une source lumineuse secondaire passe au retour dans la zone dédiée à une source lumineuse secondaire voisine, et donc la quantité de rayons lumineux susceptibles de diminuer la netteté de la zone sombre formée par les sources lumineuses éteintes, est diminuée.

On comprend que la définition d'une zone de revêtement antireflet AR1, AR2 sur au moins une face 21, 22 de la lentille L2 formant l'élément de correction de champ est dépendante de l'agencement de l'élément optique primaire 10 et plus particulièrement d'au moins un guide de lumière 11 comportant une face d'entrée 13 positionnée longitudinalement en vis-à-vis et à proximité d'une diode électroluminescente 12 associée et une face de sortie 14 formant source lumineuse secondaire. En particulier, la surface (S) minimale de la portion d'une face 21, 22 de cette lentille L2 recouverte par un revêtement antireflet AR1, AR2 dépend de la distance (D) entre la face d'entrée 13 d'un guide de lumière 11 et la face à considérer 21, 22 de la lentille L2, de la longueur (d) dudit guide de lumière 11, c'est-à-dire sa dimension longitudinale entre la face d'entrée 13 et la face de sortie 14, ainsi que de la dimension verticale ou transversale de la face de sortie 14, selon la dimension de la surface minimale de revêtement que l'on souhaite définir.

A titre d'exemple, on a illustré sur la figure 2 les dimensions à prendre en compte pour définir la hauteur H1 et la hauteur H2, c'est-à-dire la dimension selon une première direction perpendiculaire à l'axe optique et ici dimension verticale, définie par le trièdre porté sur cette figure 2, des zones de revêtement antireflet AR1, AR2. Tel que décrit précédemment, la distance (D) entre la face d'entrée du guide de lumière et la face à revêtir, ainsi que la longueur (d) du guide de lumière sont utilisées pour calculer la et selon la formule :

$$H1 = D1 * H/d$$

$$H2 = D2 * H/d,$$

avec H la hauteur, c'est-à-dire la dimension selon la dimension verticale, de la face de sortie 14 du guide de lumière 11 considéré.

Il convient que le revêtement antireflet soit disposé de manière à recouvrir l'une et/ou l'autre des faces de la lentille L2 formant élément optique de correction de champ, au moins sur cette hauteur H1, H2. On pourra ainsi utiliser une quantité minimale de revêtement antireflet et limiter le coût d'obtention du produit final. Bien entendu, si le procédé utilisé pour réaliser le recouvrement est rendu plus facile lorsque l'on recouvre la face correspondante en totalité, il est intéressant de ne pas chercher à limiter l'étendue du recouvrement à son strict minimum.

Selon l'invention, au moins une face de l'élément optique de correction de champ 20 comporte un revêtement antireflet, et plus particulièrement au moins la face d'entrée 21 concave directement en regard de l'élément optique primaire 10. On pourra prévoir une unique zone de revêtement antireflet AR1 pour recouvrir au moins une portion de cette face d'entrée 21 concave.

Selon un mode de réalisation préféré de l'invention, le revêtement antireflet, respectivement AR1 et AR2, recouvre au moins une portion de la face d'entrée 21 concave et au moins une portion de la face de sortie 22 convexe de la lentille L2 optique de correction de champ.

La présence de cette au moins une couche de revêtement antireflet permet l'obtention d'un taux de transmission des rayons lumineux à travers un dioptre de la lentille L2 formant l'élément optique de correction de champ qui est compris entre 97% et 99%. L'augmentation de ce taux de transmission, mesuré en incidence normale, par rapport à un taux standard de 95% mesuré de façon équivalente pour un dioptre en polycarbonate, permet de diminuer drastiquement la quantité de rayons amenés à revenir vers l'élément optique primaire et pouvant de la sorte pénaliser la netteté du contraste entre la zone sombre et la zone éclairé du faisceau lumineux global projeté.

On va maintenant décrire plus en détail le type de revêtement antireflet utilisé sur l'une et/ou l'autre des faces de la lentille L2 formant l'élément optique de correction de champ. Il convient de noter que le matériau utilisé dans le traitement antireflet doit être transparent sur la gamme de longueurs d'onde mises en œuvre par les sources de lumière.

Le revêtement antireflet des faces de la lentille L2 peut être un revêtement monocouche ou multicouche.

Dans le cas d'un revêtement antireflet AR monocouche, le matériau utilisé à faible indice de réfraction peut notamment consister en une monocouche de fluorure de magnésium $MgF_2$ d'une épaisseur (e) minimale de 101 nm pour un indice de réfraction n=1,36, centrée sur une longueur d'onde de 550 nm. Si l'on souhaite modifier le centrage du filtre pour un indice de réfraction connu, il suffit de changer l'épaisseur de la couche déposée. A contrario, la modification de l'épaisseur du revêtement peut permettre le décalage du centrage de l'anti-reflet : l'augmentation de l'épaisseur entraîne un décalage du centrage vers le rouge, et la diminution de cette épaisseur décale ce centrage vers le bleu.

On pourrait également, à titre d'exemple, prévoir une monocouche hybride au sein de laquelle est dispersée une pluralité de particules hybrides comportant chacune au moins deux éléments de nature et d'indice de réfraction distincts. Dans ce cas, chaque particule hybride est constituée d'un premier élément d'indice de réfraction n1 entouré d'un second élément d'indice de réfraction n2 formant une couche d'enrobage, les premier et second éléments pouvant être de nature organique et/ou inorganique et/ou polymère. De préférence, le premier élément est constitué d'au moins un alcoxyde minéral.

Dans le cas d'un revêtement antireflet multicouche, on pourra préférer un revêtement constitué d'au moins deux couches d'indices de réfraction distincts où l'épaisseur d'une couche dépend de l'indice de réfraction. De préférence le revêtement multicouche est composé d'une alternance d'au moins une couche d'un matériau à haut indice de réfraction et d'au moins une couche d'un matériau à faible indice de réfraction.

Parmi les matériaux à faible indice de réfraction, on préférera les matériaux ayant un indice de réfraction inférieur à 1,6 pour une longueur d'onde de 550 nm tels que $SiO_2$, $MgF_2$, $LiF$, $CaF_2$, $NaF$, $ZrF_4$, $AlF_3$, $Na_5Al_3F_{14}$, $Na_3AlF_6$ pris seul ou en mélange. Parmi les matériaux à haut indice de réfraction, on préférera les matériaux ayant un indice de réfraction supérieur à 1,7 pour une longueur d'onde de 550 nm tels que $ZrO_2$, $TiO_2$, $Ta_2O_5$, $Na_2O_5$, $SnO_2$, $ZnO$, $ZnS$, $HfO_2$, $Pr_2O_3$, $PrTiO_3$, $La_2O_3$, $Dy_2O_5$, $In_2O_3$, $Nb_2O_5$, $Yb_2O_3$, $Si_3N_4$, $AlN$ pris seul ou en mélange.

On comprend que la nature (monocouche, multicouche) et la composition (choix du matériau transparent dans le domaine visible) du revêtement antireflet peuvent notamment dépendre de la technique de dépôt employée pour effectuer le traitement de surface sur le substrat que constitue au moins une face 21, 22 de la lentille L2 optique de correction de champ.

On va maintenant décrire le procédé de fabrication d'une lentille L2 formant l'élément optique de correction de champ qui comporte au moins une étape d'application d'un revêtement antireflet AR.

Dans un premier mode de réalisation de ce procédé, l'étape d'application consiste à déposer au moins une couche de revêtement antireflet AR selon un procédé sous vide, de préférence par dépôt physique en phase vapeur, connu également sous la dénomination de « physical vapor deposition (PVD) », basée sur une méthode d'évaporation consistant à chauffer le matériau de revêtement antireflet pour qu'il s'évapore en direction du substrat et se condense à sa surface pour former la couche désirée.

Dans le cas d'un revêtement antireflet AR monocouche obtenu par une opération de type PVD, un matériau à faible indice de réfraction, de préférence du fluorure de magnésium $MgF_2$ (indice de réfraction 1,36), est déposé dans une chambre vide où la pression est de l'ordre de $10^{-4}$ mbar. Par évaporation thermique dans la chambre sous vide, le matériau, placé dans un creuset en molybdène, est chauffé par un filament de tungstène jusqu'à atteindre sa température d'évaporation. Le matériau vient ensuite se déposer sur le substrat, ici la face d'entrée et/ou la face de sortie de la lentille L2, en une couche unique. L'épaisseur de la couche est contrôlée en continue par une balance à quartz de manière à stopper le dépôt lorsque l'épaisseur visée pour obtenir un effet antireflet monocouche centré à la longueur d'onde souhaitée est atteinte. A titre d'exemple, le revêtement antireflet peut être est une monocouche de $MgF_2$ centrée à 550 nm. La réflexion minimale étant atteinte à un quart d'onde, la valeur d'épaisseur visée est de 101 nm avec un indice de réfraction de 1,36 à 550 nm.

On saura appliquer le même type de procédé dans le cas d'un revêtement antireflet multicouches, par l'évaporation successive des différents matériaux utilisés, dès lors qu'une couche d'épaisseur suffisante est obtenue.

Dans un second mode de réalisation de ce procédé, l'étape d'application consiste à déposer au moins une couche de revêtement antireflet AR selon un procédé dit « sol-gel » par une technique de dépôt par voie liquide réalisée à pression atmosphérique et à température ambiante qui peut être un dépôt par trempage (« dip coating »), un dépôt par enduction centrifuge (« spin coating »), un dépôt par pulvérisation (« spray coating ») ou encore par enduction laminaire.

On pourra notamment privilégier la technique de dépôt par trempage qui consiste à immerger la lentille formant l'élément optique de correction de champ dans la solution sol-gel, puis à retirer ce substrat à vitesse constante. Cette technique présente l'avantage de déposer simultanément une couche de revêtement sur chaque face 21, 22 de la lentille L2 formant le substrat. Cette technique de dépôt par trempage permet d'obtenir une monocouche hybride de revêtement antireflet, dont l'épaisseur est variable en fonction du centrage souhaité de l'anti-reflet. Notamment, pour un indice de réfraction de la monocouche hybride obtenue compris entre 1,32 et 1,36, l'épaisseur pour un centrage à 550 nm peut être comprise entre 101 et 110 nm. De manière plus générale, on pourra prévoir à titre d'exemple une épaisseur de revêtement comprise entre 10 nanomètres et 10 micromètres.

Dans un mode préféré de réalisation, l'étape de dépôt par trempage est réalisée à température ambiante de 20 à 25°C, sous humidité relative de 30 à 60% à 22°C. Dans ces conditions, la vitesse de retrait recommandée est de 1,6 mm/s. Avantageusement, le substrat recouvert du revêtement antireflet est placé, à l'issue de la gélification, dans une étuve pour recevoir un traitement thermique de séchage, de préférence à 90°C pendant 2 heures.

L'application d'un revêtement antireflet AR sur au moins une face de la lentille L2 formant élément optique de correction de champ a pour effet de réduire la quantité de lumière non transmise d'au moins de moitié pour une longueur d'ondes donnée de 450 nm et/ou de 550 nm.

La description qui précède explique clairement comment l'invention permet d'atteindre les objectifs qu'elle s'est fixée et notamment de proposer une lentille optique de correction de champ dans un module lumineux configuré pour former un faisceau adaptatif, et notamment une lentille dont la concavité de la face agencée en regard des sources de lumière pose un problème de retour des rayons émis par une zone correspondant à des sources de lumières allumées vers une zone correspondant à des sources de lumière éteintes, qui est recouverte d'un revêtement antireflet.

Tel que cela a pu être évoqué précédemment, des variantes sont possibles et l'invention ne saurait se limiter aux modes de réalisation spécifiquement donnés dans ce document à titre d'exemples non limitatifs.

## Revendications

1. Module lumineux (1) d'éclairage adaptatif pour véhicule automobile comportant un élément optique de correction de champ (20) configuré pour être en travers de rayons lumineux émis par une pluralité de sources lumineuses, l'élément optique comprenant une face d'entrée (21) de rayons lumineux et une face de sortie (22) de ces rayons lumineux, au moins une portion de la face d'entrée (21) étant recouverte d'un revêtement antireflet (AR1) apte à diminuer la réflexion d'une partie des rayons lumineux par cette face d'entrée ledit module lumineux comportant en outre :

   - des sources lumineuses primaires (12) configurées pour émettre des rayons lumineux depuis un plan (P) commun d'émission orthogonal à l'axe optique du module lumineux,
   - un élément optique primaire (10) comportant une portion avant (18) formant lentille (L1) et une portion arrière (17) qui comporte une pluralité de guides de lumières (11), chaque guide de lumière (11) comportant une face d'entrée (13) de rayons lumineux émis par une source lumineuse primaire (12) associée et une face de sortie (14) de ces rayons lumineux en direction de la portion avant (18) formant lentille (L1), et
   - une optique de projection (30) apte à projeter une image des faces de sortie pour former un faisceau lumineux global adaptatif,

   l'élément optique formant correction de champ (20) étant agencé sur l'axe optique du module lumineux entre l'élément optique primaire (10) et l'optique de projection (30), la face d'entrée (21) recouverte au moins partiellement d'un revêtement antireflet (AR1) étant tournée vers l'élément optique primaire (10).

2. Module lumineux selon la revendication 1, **caractérisé en ce que** la face d'entrée (21) de l'élément optique de correction de champ (20) est concave.

3. Module lumineux selon l'une quelconque des revendications 1 ou 2, **caractérisé en ce que** le dioptre formé au niveau de la face d'entrée de l'élément optique de correction de champ (20) et son revêtement antireflet est configuré pour présenter un taux de transmission au moins égal à 97%.

4. Module lumineux selon l'une des revendications 1 ou 2, **caractérisé en ce qu'**au moins une portion de la face de sortie (22) de l'élément optique de correction de champ (20) est recouverte d'un revêtement antireflet (AR2).

5. Module lumineux selon la revendication 3, **caractérisée en ce que** la face de sortie (22) de l'élément optique de correction de champ (20) est convexe.

6. Module lumineux selon l'une quelconque des revendications 1 à 5, **caractérisée en ce que** le revêtement antireflet (AR1, AR2) de l'élément optique de correction de champ (20) est un revêtement monocouche de matériau à faible indice de réfraction, de préférence de fluorure de magnésium MgF2.

7. Module lumineux selon la revendication précédente, **caractérisée en ce que** la monocouche dudit matériau à faible indice de réfraction présente une épaisseur (e) égale à :

$$(e) = \lambda / 4.n \ ,$$

avec $\lambda$ la longueur d'onde du centrage de l'anti-reflet et n l'indice de réfraction dudit matériau.

8. Module lumineux selon l'une quelconque des revendications 1 à 5, **caractérisée en ce que** le revêtement antireflet (AR1, AR2) est un revêtement monocouche hybride dans laquelle est dispersée une pluralité de particules hybrides constituée d'un premier élément d'indice de réfraction n1 entouré d'un second élément d'indice de réfaction n2 formant une couche d'enrobage.

9. Module lumineux selon l'une des revendications précédentes, **caractérisé en ce que** la portion d'une face (21, 22) de l'élément optique de correction de champ (20) recouverte par un revêtement antireflet (AR1, AR2) s'étend sur une hauteur (H), selon une première direction perpendiculaire à l'axe optique (A), qui dépend de la distance (D) entre la face d'entrée (13) d'un guide de lumière (11) et la face (21, 22) de cet élément optique (20) et de la longueur (1) dudit guide de lumière (11), ainsi que de la hauteur (H), selon la première direction, du guide de lumière (11) au niveau de sa face de sortie (14), selon la formule :

$$(H1, H2) = (D1, D2) * H/d$$

**Patentansprüche**

1. Leuchtmodul (1) zur adaptiven Beleuchtung für ein Kraftfahrzeug, umfassend ein optisches Feldkorrekturelement (20), das dazu ausgestaltet ist, quer zu von einer Mehrzahl von Lichtquellen emittierten Lichtstrahlen zu sein, wobei das optische Element eine Eintrittsfläche (21) für Lichtstrahlen und eine Austrittsfläche (22) für diese Lichtstrahlen beinhaltet, wobei mindestens ein Abschnitt der Eintrittsfläche (21) mit einer Antireflex-Beschichtung (AR1) bedeckt ist, die geeignet ist, die Reflexion eines Teils der Lichtstrahlen durch diese Eintrittsfläche zu verringern, wobei das Leuchtmodul ferner umfasst:

   - primäre Lichtquellen (12), die dazu ausgestaltet sind, Lichtstrahlen von einer gemeinsamen Emissionsebene (P) aus, die rechtwinklig zur optischen Achse des Leuchtmoduls verläuft, zu emittieren,
   - ein primäres optisches Element (10), umfassend einen eine Linse (L1) bildenden vorderen Abschnitt (18) und einen hinteren Abschnitt (17), der eine Mehrzahl von Lichtleitern (11) umfasst, wobei jeder Lichtleiter (11) eine Eintrittsfläche (13) für von einer zugeordneten primären Lichtquelle (12) emittierte Lichtstrahlen und eine Austrittsfläche (14) für diese Lichtstrahlen in Richtung des eine Linse (L1) bildenden vorderen Abschnitts (18) umfasst, und
   - eine Projektionsoptik (30), die geeignet ist, ein Bild der Austrittsflächen zu projizieren, um einen adaptiven globalen Lichtstrahl zu bilden,

   wobei das eine Feldkorrektur bildende optische Element (20) auf der optischen Achse des Leuchtmoduls zwischen dem primären optischen Element (10) und der Projektionsoptik (30) angeordnet ist, wobei die mindestens teilweise mit einer Antireflex-Beschichtung (AR1) bedeckte Eintrittsfläche (21) dem primären optischen Element (10) zugewandt ist.

2. Leuchtmodul nach Anspruch 1, **dadurch gekennzeichnet, dass** die Eintrittsfläche (21) des optischen Feldkorrekturelements (20) konkav ist.

3. Leuchtmodul nach einem der Ansprüche 1 oder 2, **dadurch gekennzeichnet, dass** der an der Eintrittsfläche des optischen Feldkorrekturelements (20) gebildete Diopter und seine Antireflex-Beschichtung dazu ausgestaltet sind, einen Transmissionsgrad von mindestens 97 % aufzuweisen.

4. Leuchtmodul nach einem der Ansprüche 1 oder 2, **dadurch gekennzeichnet, dass** mindestens ein Abschnitt der Austrittsfläche (22) des optischen Feldkorrekturelements (20) mit einer Antireflex-Beschichtung (AR2) bedeckt ist.

5. Leuchtmodul nach Anspruch 3, **dadurch gekennzeichnet, dass** die Austrittsfläche (22) des optischen Feldkorrekturelements (20) konvex ist.

6. Leuchtmodul nach einem der Ansprüche 1 bis 5, **dadurch gekennzeichnet, dass** die Antireflex-Beschichtung (AR1, AR2) des optischen Feldkorrekturelements (20) eine Einfachschicht-Beschichtung aus Material mit niedrigem Brechungsindex ist, bevorzugt aus Magnesiumfluorid MgF2.

7. Leuchtmodul nach dem vorhergehenden Anspruch, **dadurch gekennzeichnet, dass** die Einfachschicht des Materials mit niedrigem Brechungsindex eine Dicke (e) aufweist gleich:

$$(e) \quad \lambda \ / \ 4.n,$$

   wobei $\lambda$ die Wellenlänge der Anti-Reflex-Zentrierung ist und n der Brechungsindex des Materials ist.

8. Leuchtmodul nach einem der Ansprüche 1 bis 5, **dadurch gekennzeichnet, dass** die Antireflex-Beschichtung (AR1, AR2) eine hybride Einfachschicht-Beschichtung ist, in der eine Mehrzahl von hybriden Partikeln verteilt ist, die aus einem ersten Element mit dem Brechungsindex n1 zusammengesetzt ist, das von einem zweiten Element mit dem Brechungsindex n2 umgeben ist, das eine Überzugsschicht bildet.

9. Leuchtmodul nach einem der vorhergehenden Ansprüche, **dadurch gekennzeichnet, dass** der Abschnitt einer Fläche (21, 22) des optischen Feldkorrekturelements (20), der mit einer Antireflex-Beschichtung (AR1, AR2) bedeckt ist, sich über eine Höhe (H), entlang einer ersten Richtung senkrecht zur optischen Achse (A), erstreckt, die von dem Abstand (D) zwischen der Eintrittsfläche (13) eines Lichtleiters (11) und der Fläche (21, 22) dieses optischen Elements (20) und von der Länge (1) des Lichtleiters (11) abhängt sowie von der Höhe (H), entlang der ersten Richtung, des Lichtleiters (11) an seiner Austrittsfläche (14), nach der Formel:

$$(H1, \ H2) \ = \ (D1, \ D2) \ * \ H/d$$

**Claims**

1. Adaptive lighting luminous module for automotive vehicle, including a field-correcting optical element (20) configured to be arranged crosswise to light rays emitted by a plurality of light sources, the optical element comprising an entrance face (21) through which light rays enter and an exit face (22) through which these light rays exit, at least one segment of the entrance face (21) being covered with an antireflection coating (AR1) that is able to decrease the reflection of some of the light rays by this entrance face :

said luminous module further including :

- primary light sources (12) that are configured to emit light rays from a common emission plane (P) that is orthogonal to the optical axis of the luminous module;
- a primary optical element (10) that includes a front segment (18) forming a lens (L1) and a back segment (17) that includes a plurality of light guides (11), each light guide (11) including an entrance face (13) through which light rays emitted by a primary light source (12) enter and an exit face (14) through which these light rays exit in the direction of the front segment (18) forming said lens (L1); and
- a projecting optic (30) that is able to project an image of the exit faces in order to

form an overall adaptive light beam,

the field-correcting optical element (20) being arranged on the optical axis of the luminous module between the primary optical element (10) and the projecting optic (30), the entrance face (21), which is at least partially covered with an antireflection coating (AR1), being turned towards the primary optical element (10).

2. Luminous module according to Claim 1, **characterized in that** the entrance face (21) of the field-correcting optical element (20) is concave.

3. Luminous module according to either of Claims 1 and 2, **characterized in that** the dioptric interface formed between the entrance face of the field-correcting optical element (20) and its antireflection coating is configured to have a transmittance at least equal to 97%.

4. Luminous module according to either of Claims 1 and 2, **characterized in that** at least one segment of the exit face (22) of the field-correcting optical element (20) is covered with an antireflection coating (AR2).

5. Luminous module according to Claim 3, **characterized in that** the exit face (22) of the field-correcting optical element (20) is convex.

6. Luminous module according to any one of Claims 1 to 5, **characterized in that** the antireflection coating (AR1, AR2) of the field-correcting optical element (20) is a monolayer coating of low-refractive-index material, preferably magnesium fluoride $MgF_2$.

7. Luminous module according to the preceding claim, **characterized in that** the monolayer of said low-refractive-index material has a thickness (e) equal to:

$$(e) = \lambda / 4.n \quad ,$$

where $\lambda$ is the wavelength of the centrepoint of the antireflection and n the refractive index of said material.

8. Luminous module according to any one of Claims 1 to 5, **characterized in that** the antireflection coating (AR1, AR2) is a hybrid monolayer coating in which are dispersed a plurality of hybrid particles consisting of a first element of refractive index n1 surrounded by a second element of refractive index n2 forming a coating layer.

9. Luminous module according to one of the preceding Claims, **characterized in that** that segment of a face (21, 22) of the field-correcting optical element (20) which is covered with an antireflection coating (AR1, AR2) extends over a height (H), in a first direction perpendicular to the optical axis (A), that depends on the distance (D) between the entrance face (13) of a light guide (11) and the face (21, 22) of this optical element (20), on the length (1) of said light guide (11), and on the height (H), in the first direction, of the light guide (11) at its exit face (14), according to the formula:

$$(H1, H2) = (D1, D2) * H/d$$

Fig. 1

Fig. 2

**EP 3 421 875 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2017015684 A1

- EP 3301349 A1